# EUROPEAN PATENT APPLICATION

(11) **EP 1 916 705 A2**
(43) Date of publication of application: **30.04.2008**
(21) Application number: 07075906.3
(22) Date of filing: 23.10.2007
(51) Int. Cl.: H01L 21/28, H01L 29/49, H01L 21/3215, H01L 21/8238

(54) **Semiconductor device comprising a doped metal comprising main electrode**

(30) Priority: 23.10.2006 US 853628 P; 10.01.2007 US 884346 P
(71) Applicant: Interuniversitair Microelektronica Centrum (IMEC), 3001 Leuven (BE); Texas Instruments Incorporated, Dallas, Texas 75265 (US); Taiwan Semiconductor Manufacturing Company, Ltd. (TSMC), Hsinchu 300-077 (TW)
(72) Inventor: Chang, Shou-Zen, 3080 Tervuren (BE); Kittl, Jorge Adrian, 1410 Waterloo (BE); Yu, Hong Yu, 3001 Leuven (BE); Lauwers, Anne, 2630 Aartselaar (BE); Veloso, Anabela, 3001 Leuven (BE)
(74) Representative: Bird, Ariane

(57) **Abstract**

The present invention provides a semiconductor device comprising a main electrode (4) and a dielectric (3) in contact with the main electrode (4), the main electrode (4) comprising a material having a work function and a work function modulating element (6) for modulating the work function of the material of the main electrode (4) towards a predetermined value. The main electrode (4) furthermore comprises a diffusion preventing dopant element (5) for preventing diffusion of the work function modulating element (6) towards and/or into the dielectric (3). The present invention also provides a method for forming such a semiconductor device.

## Description

### Technical field of the invention

The present invention relates to semiconductor devices. More particularly, the present invention relates to a semiconductor device such as a field effect transistor, the device comprising a main electrode and a dielectric in contact with the main electrode, the main electrode comprising a material having a work function and a work function modulating element for modulating the work function of the material of the main electrode. The invention also relates to a method for forming a semiconductor device.

### Background of the invention

In mainstream semiconductor technology metal oxide semiconductor field effect transistor (MOSFET) devices may be used as basic elements, either as switching element or as charge storage element. A MOSFET device comprises a semiconductor channel region which is dielectrically coupled to a gate electrode via a gate dielectric. The semiconductor channel region is contacted at opposite sides by a source junction and a drain junction.

Generally polysilicon is used as a gate electrode material. However, in order to improve the performance of MOSFET devices polysilicon has been replaced as a gate electrode material by metallic materials, such as metal silicides. Such metallic gates do not suffer from shortcomings that are related to semiconducting gate electrodes such as, for example, gate depletion, dopant diffusion or medium range resistance. Recently, there has been significant interest in the application of silicides as metallic gate electrodes. In particular fully-silicided (FUSI) gates show to be promising candidates. From a processing point of view, a FUSI gate can be implemented as a variation on the self-aligned silicidation process used in previous technology nodes e.g. to reduce the sheet resistance of semiconductor regions. In the FUSI-approach first a polysilicon gate electrode is formed and then the silicide is formed in the gate electrode down to its interface with the gate dielectric thereby fully consuming the polysilicon material of the gate electrode.

Ni-silicide appears to be an attractive candidate to form a gate electrode because it allows maintaining several aspects of the process flow applied in prior CMOS technology generations, such as patterning of the silicon gate and the self-aligned silicide-forming processes. A key property that has attracted attention to NiSi FUSI gates is the possibility to modulate their effective work function on a SiO₂ gate dielectric by dopants which may allow for tuning of the threshold voltage (Vₜ) of nMOS and pMOS devices without the need for using a different bulk material for the gate electrode for forming both types of MOSFET. The integration and properties of Ni FUSI gates on high-k dielectrics is also of interest for advanced CMOS applications.

In "Modulation of the Ni FUSI work function by Yb doping: from midgap to n-type band-edge" in technical digest IEDM meeting 2005, p630-633,H.Y., Yu et al. discloses a method for modulating the work function of a nickel silicide FUSI gate formed on a SiON gate dielectric by incorporating ytterbium in the nickel-silicon gate electrode. The work function of the Ni FUSI gate is reduced from 4.72eV to 4.22eV by doping with Yb. It was also reported that Yb is piled up at the interface between the gate electrode and the gate dielectric, which may promote diffusion of the Yb towards the gate dielectric.

Not only have there been attempts to replace the polysilicon gate electrode by a metallic gate electrode, but also attempts have been made to reduce the thickness of the gate dielectric layer. The thickness of a conventional silicon oxide gate dielectric has reached its practical limits. The equivalent electrical oxide thickness (EEOT) of the dielectric material needs to be in the 0.5 nm to 2 nm range to ensure good dielectric coupling. However, silicon oxide layers with a thickness of 0.5 nm to 2nm may not be able to withstand voltages applied and thus a thicker dielectric is needed. This leads to the use of high-k dielectric materials which offer a sufficient physical thickness and a limited EEOT, the ratio being defined by the dielectric constant (k-value) of the dielectric material. For this purpose, other materials are being investigated as alternative materials to form the gate dielectric. In first instance silicon oxynitride is used as an alternative gate dielectric material. Other alternative dielectric materials are being considered which have an EEOT of a few nanometers but have a larger physical thickness. As these alternative materials are characterized by a higher dielectric constant compared to the dielectric constant of silicon oxide (k=3.9), they have been called high-k dielectric materials. These high-k dielectric materials have a k-value in the range between 4 to 40. Some examples of these high-k materials are oxides or silicates of hafnium, tantalum and zirconium which have a k-value in the range of between 20 and 26.

When fabricating a MOSFET device having a FUSI gate electrode comprising a dopant, in particular a work function modulating element, it has been observed that the electrical characteristics of the MOSFET device deviate from a MOSFET device without such dopant. In particular, if an ytterbium doped nickel FUSI gate electrode of an n-type MOSFET is formed in particular on a silicon oxynitride gate dielectric, the leakage current through the gate dielectric may increase compared to an ytterbium-free nickel FUSI gate electrode. This leakage current increases with decreasing gate dielectric thickness. Also the capacitance-voltage characteristics of such gate stack show anomalies which indicate the presence of a larger number of interface states Dᵢₜ. Moreover it has been observed that the work function of the nickel ytterbium FUSI gate may vary with time.

### Summary of the invention

It is an object of embodiments of the present invention to provide a good semiconductor device and a good method for making such a semiconductor device.

The semiconductor devices according to embodiments of the invention solve the problem of high leakage currents when work function modulating elements are used to modulate the work function of the material a main electrode, e.g. gate of the semiconductor device is formed of.

The above objective is accomplished by a method and device according to the present invention.

In a first aspect, the present invention provides a semiconductor device comprising a main electrode and a dielectric in contact with the main electrode, the main electrode comprising a material having a work function and a work function modulating element for modulating, e.g. changing, the work function of the material of the main electrode towards a predetermined value. The main electrode furthermore comprises a diffusion preventing dopant element for preventing diffusion of the work function modulating element towards and/or into the dielectric.

If only a work function modulating element would be provided to the gate electrode, the work function modulating element would tend to diffuse towards the gate dielectric. By providing a diffusion preventing dopant element according to embodiments of the invention, this diffusion of the work function modulating element may be prevented by interaction between both elements.

The main electrode may be a fully silicided main electrode and the material of the main electrode may comprise an alloy of a semiconductor material and a metal. According to embodiments of the invention, the semiconductor material may comprise silicon or germanium. According to embodiments of the invention, the metal may be a metal that forms an alloy having a midgap work function. In that way, midgap materials may be formed which are suitable to be used for n-type devices and for p-type devices. Furthermore, because the difference in work function of the gate and of the channel is reduced, the threshold voltage Vₜ of the device may also be reduced.

The material of the main electrode may comprise a metal.

According to embodiments of the invention, the diffusion preventing dopant element may be one of P, As, Sb, Ge or Si.

The concentration of diffusion preventing dopant elements in the main electrode may be between 1e14 cm⁻³ and 1e16 cm⁻³.

The work function modulating element may be selected to form a material with an n-type work function. Therefore, the work function modulating element may be selected from the group of lanthanides and may, for example, be Ytterbium.

The concentration of work function modulating elements in the main electrode may be between 1e14 cm⁻³ and 1e16 cm⁻³.

The metal in the alloy of the main electrode may be nickel.

The dielectric may be a silicon-oxide, a silicon oxynitride or a high-k dielectric.

In a further aspect, the present invention provides a method for forming a semiconductor device. The method comprises:
- forming a main electrode structure comprising a main electrode and a dielectric in contact with the main electrode, the main electrode comprising a material having a work function,
- providing a work function modulating element to the main electrode for modulating, e.g. changing, the work function of the material of the main electrode towards a predetermined value, and
- providing a diffusion preventing dopant element to the main electrode for preventing diffusion of the work function modulating element towards and/or into the dielectric.

Forming a main electrode structure may comprise:
- providing on a substrate a dielectric layer and a layer of main electrode material to form a main electrode stack, and
- patterning the main electrode stack to form the main electrode.

According to embodiments of the invention, the main electrode may comprise an alloy of a semiconductor material and a metal and the method may furthermore comprise, after patterning the main electrode stack:
- providing a layer of metal on the main electrode, and
- silicidizing the main electrode.

According to embodiments of the invention, providing the work function modulating element may be performed before providing the diffusion preventing dopant element.

According to other embodiments of the invention, providing the work function modulating element may be performed after providing the diffusion preventing dopant element.

Preferably the work function modulating element and the diffusion preventing dopant element may be close together so as to make interaction between both possible.

According to embodiments of the invention, providing the work function modulating element may be performed before or after patterning the main electrode stack.

According to further embodiments of the invention, providing the diffusion preventing dopant element may be performed before or after patterning the main electrode stack.

Providing the diffusion preventing dopant element may be performed by ion implantation.

According to embodiments of the invention, providing the work function modulating element may be performed by ion implantation.

According to other embodiments of the invention, providing the work function modulating element may be performed by providing a layer of the work function modulating element and performing a thermal anneal.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Exemplary embodiments of the present invention are illustrated in referenced figures of the drawings. It is intended that the embodiments and figures disclosed herein should be considered illustrative rather than restrictive.

Figure 1 is a schematic cross-section of a MOSFET device according to an embodiment of the present invention.

Figure 2 is a graph showing the gate capacitance as function of the gate voltage, obtained for a capacitor structure comprising a prior art Yb-doped NiSi FUSI gate electrode (curve 20) and a Yb+P-doped NiSi FUSI gate electrode according to an embodiment of the present invention (curve 21).

Figure 3 is a graph showing the gate current density as function of the gate voltage, obtained for a capacitor structure comprising a prior art NiSi FUSI gate electrode (curve 22) and a Yb+P doped NiSi FUSI gate electrode according to an embodiment of the present invention (curve 23).

Figure 4 is a graph showing the gate capacitance as function of the gate voltage, obtained for a capacitor structure comprising a prior art NiSi FUSI gate electrode (curve 24), a prior art Yb-doped NiSi FUSI gate electrode (curve 25), a prior art P-doped NiSi FUSI gate electrode (curve 26) and an Yb+P doped NiSi FUSI gate electrode according to an embodiment of the present invention (curve 27).

Figures 5a to 5i illustrate by means of schematic cross-sections subsequent steps in a process flow for fabricating a semiconductor device according to an embodiment of the present invention.

Figure 6 shows a flowchart illustrating a fabrication process as illustrated in Figures 4a to 5i.

Figures 7a to 7e show schematic cross-sections illustrating subsequent steps of a process flow for fabricating a semiconductor device according to an embodiment of the present invention.

Figures 8a to 8e show schematic cross-sections illustrating subsequent steps of a process flow for fabricating a semiconductor device according to an embodiment of the present invention.

Figures 9a to 9d show schematic cross-sections illustrating subsequent steps of a process flow for fabricating a semiconductor device according to an embodiment of the present invention.

Figures 10a to 10e show schematic cross-sections illustrating subsequent steps of a process flow for fabricating a semiconductor device according to an embodiment of the present invention.

Figures 11a to 11d illustrate by means of schematic cross-sections subsequent steps from a process flow according to an embodiment subsequent steps in a process flow for fabricating a semiconductor device according to an embodiment of the present invention.

Figures 12a to 12d illustrate by means of schematic cross-sections subsequent steps from a process flow according to an embodiment subsequent steps in a process flow for fabricating a semiconductor device according to an embodiment of the present invention.

In the figures, the same reference signs refer to the same or similar elements.

### Description of illustrative embodiments

The present invention will be described with respect to particular embodiments and with reference to certain drawings, but the invention is not limited thereto but is only limited by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true technical teaching of the invention, the invention being limited only by the terms of the appended claims.

In the following certain embodiments will be described with reference to devices structures such as transistors. These are three-terminal devices having a first main electrode such as a drain, a second main electrode such as a source and a control electrode such as a gate for controlling the flow of electrical charges between the first and second main electrodes. However, the invention is not limited thereto. For example, the embodiments may be applied to other device structures such as metal-insulator-metal capacitors or to memory devices such as DRAM or non-volatile memories.

The present invention provides a semiconductor device comprising a main electrode, e.g. a gate electrode, which comprises a material with a particular work function, e.g. a metal or metal silicide, and a method for manufacturing such a semiconductor device.

In the following description, the term "transistor" is intended to refer to a semiconductor device comprising a semiconductor channel region which is dielectrically coupled to a gate electrode via a gate dielectric. The semiconductor channel region is contacted at opposite sides by a source junction and a drain junction. Various types of transistor architectures are already known in the art. In a planar gate device the channel region is only controlled by the gate electrode from one side. Planar gate devices can be formed on a bulk semiconductor substrate or on a semiconductor-on-insulator substrate. For multi-gate devices the channel of the device is controlled by the gate electrode from multiple sides. The body of semiconductor material wherein the channel is formed is made as thin as possible to allow a more efficient control by the gate electrode. For example, the body of a fin-FET may have a thickness in the range of between 10 nm and 100 nm. In 32 nm technology for example the fin width may be in the range of between 10 nm and 20 nm.

In the following description, embodiments of the invention will be described with reference to a silicon substrate, but it should be understood that the invention also applies to other semiconductor substrates. In embodiments of the invention, the "substrate" may include a semiconductor substrate such as e.g. a silicon (Si), a gallium arsenide (GaAs), a gallium arsenide phosphide (GaAsP), an indium phosphide (InP), a germanium (Ge) or a silicon germanium (SiGe) substrate. The "substrate" may include for example, an insulating layer such as a SiO₂ or a Si₃N₄ layer in addition to a semiconductor substrate portion. Thus, the term substrate also includes semiconductor-on-insulator substrates such as silicon-on-glass, silicon-on sapphire substrates, silicon-on-insulator(SOI) substrates, germanium-on-insulator substrates (GOI). The term "substrate" is thus used to define generally the elements or layers that underlie a layer or portions of interest. Accordingly, a substrate may be a wafer such as a blanket wafer or may be a layer applied to another base material, e.g. an epitaxial semiconductor layer grown onto a lower layer. The term "crystalline substrate" is intended to include various forms of crystalline material, such as monocrystalline or microcrystalline.

In the following embodiments with "silicide" or "metal silicide" is meant a compound formed of one or more metals with a semiconductor material, such as silicon, germanium or silicon-germanium. In the context of the present invention, the terms "silicide", "silicided", "silicidation" or similar terms can refer to the reaction between a metal and silicon, but is not intended to be limited to silicon. For instance, the reaction of a metal with germanium, or any other suitable semiconductor material such as silicon-germanium, may still be referred to as silicidation. Silicides may easily be formed by a thermal reaction of a variety of metals with silicon. Silicides may typically be formed in a two step process, i.e. a first thermal treatment at a first temperature and a second thermal treatment at a second temperature higher than the first temperature. In between the two thermal steps, unreacted metal may selectively be removed. The second thermal step may be to reduce the sheet resistance of the silicide and/or to obtain a complete silicidation of the semiconductor material in contact with the silicide. The thermal treatment may preferably be done using rapid thermal processing. The parameters of the thermal process, e.g. time and temperature, are selected in view of the silicide to be formed.

In the following the work function of a material is to interpreted as the minimum energy that is needed to remove an element (electron) from the solid material.

A fully silicided (FUSI) gate electrode is formed by a reaction between silicide-forming metals and the semiconductor gate electrode, thereby fully consuming the semiconductor material of the gate electrode.

In a first aspect of the invention, a semiconductor device is provided. The semiconductor device comprises a main electrode, e.g. a gate electrode, and a dielectric, e.g. gate dielectric, in contact with the main electrode, e.g. gate electrode, the main electrode, e.g. gate electrode comprising a material having a work function and a work function modulating element for modulating the work function of the material of the main electrode, e.g. gate electrode, towards a predetermined value. The main electrode, e.g. gate electrode furthermore comprises a diffusion preventing dopant element for preventing diffusion of the work function modulating element towards and/or into the dielectric, e.g. gate dielectric.

With predetermined value of a workfunction is meant a suitable value required or desired so as to obtain a p-type or an n-type device (see further).

The semiconductor device according to embodiments of the invention will be described by means of a MOSFET transistor. It has to be understood that this is only for ease of explanation and the description is not intended to limit the invention in any way. The present invention also applies to other types of transistors, and, more generally, to any other semiconductor device as described herein.

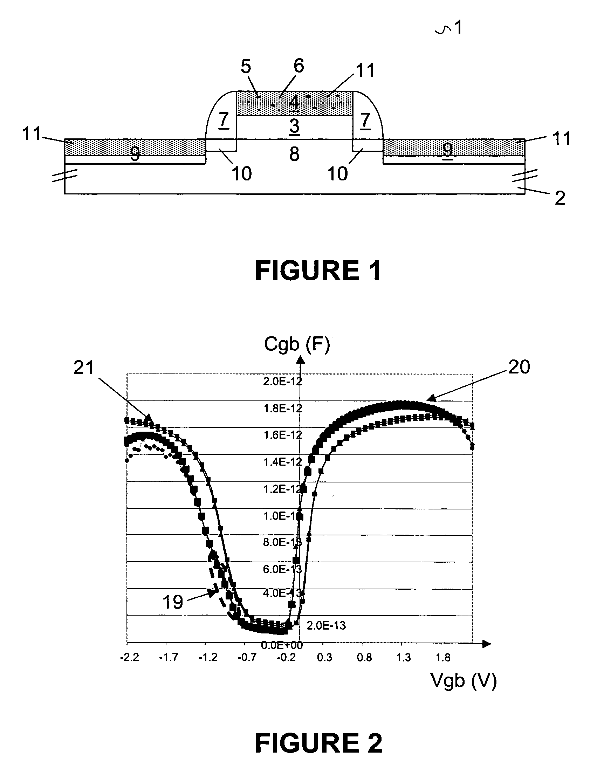

Figure 1 shows a schematic cross-section of a MOSFET device 1 according to an embodiment of the invention. The MOSFET device 1 may be formed using a method according to an embodiment of the invention as will be described hereafter. In the method according to embodiments of the invention, standard CMOS processes known by a person skilled in the art may be used for process steps such as e.g. depositing layers or implanting ions.

The MOSFET device 1 comprises a gate stack formed of a gate dielectric 3 and a fully silicided (FUSI) gate electrode 4, the FUSI gate electrode 4 comprising an alloy of a semiconductor material, e.g. silicon, germanium or silicon-germanium, and a suitable silicide-forming metal. According to another embodiment the gate electrode 4 may be formed of a metal. The MOSFET device 1 may be formed on a substrate 2. In the substrate 2 lowly doped junction regions 10 may be present which are aligned to the gate stack 3, 4. The MOSFET device 1 may furthermore comprise sidewall spacers 7 against sidewalls of the gate stack 3, 4. These sidewall spacers 7 may comprise a dielectric material such as, for example, silicon oxide, silicon nitride, silicon carbide or a combination thereof. Aligned to the sidewall spacers 7 highly doped junction regions 9 may be present in the substrate 2. The lowly doped regions 10 and the highly doped regions 9 may form source and drain regions of the MOSFET device 1. The source and drain regions may be formed on opposite sides of a channel region 8.

As described above, the gate electrode 4 may be a fully silicided gate electrode 3 comprising an alloy of semiconductor material with a silicide-forming metal. According to other embodiments of the invention, the gate electrode 3 may be formed of a metal. The material of the gate electrode 3 has a particular work function. Gate electrode 3 further comprises a work function modulating element 6 for modulating the work function of the material of the gate electrode as well as a diffusion preventing dopant element 5 for preventing diffusion of the work function modulating element 6 toward the gate dielectric 3. The work function modulating element 6 is selected to tune the work function of the material of the gate electrode, for instance metal silicide or metal, towards a selected, predetermined value. The diffusion preventing dopant element 5 is selected to interact with the work function modulating element 6 such that this work function modulating element 6 does not substantially diffuse towards and/or into the gate dielectric 3.

The MOSFET device 1 according to the embodiment comprises a FUSI or metal gate electrode 4 in contact with a gate dielectric 3. In case the gate electrode 4 is a FUSI gate electrode, the electrode may comprise a semiconductor material such as silicon, germanium or silicon-germanium, a silicide-forming metal, a first dopant element referred to as diffusion preventing dopant element 5 and a second dopant element referred to as a work function modulating element 6. The work function modulating element 6 is selected to shift the work function of the material of the gate electrode 4, in the example given the work function of the metal silicide, towards a predetermined value, e.g. towards the valence band of the semiconductor material if the MOSFET device 1 is a p-type MOSFET device or towards the conductance band of the semiconductor material if the MOSFET device 1 is an n-type MOSFET device. The diffusion preventing dopant element 5 and the work function modulating element 6 are selected to interact with each other such that diffusion of at least one of the diffusion preventing dopant element 5 and the work function modulating element 6 towards the gate dielectric 3 is impeded. If only a work function modulating element 6 would be provided to the gate electrode 4, the work function modulating element 6 would tend to diffuse towards the gate dielectric 3. By providing a diffusion preventing dopant element 5 according to embodiments of the invention, this diffusion of the work function modulating element 6 may be prevented by interaction between both elements 5, 6. Therefore, preferably the diffusion preventing dopant element 5 and the work function modulating element 6 may be provided in a 1:1 ratio, or in other words the concentration of the diffusion preventing dopant element 5 and the work function modulating element 6 may be substantially equal to each other. Both the work function modulating element and the diffusion preventing dopant element apply forces to each other so as to help each other to stay within the gate electrode. The diffusion preventing dopant element 5 and the work function modulating element 6 are selected to interact with each-other such that the final dopant distributions close to the interface between the gate electrode 4 and the gate dielectric 3 is modulated and the number of interface states at that interface is reduced.

In the context of the present invention a suitable metal for silicidation may be a metal such as nickel or platinum or may be a refractory metal such as cobalt, tungsten or titanium. In case a n-type MOSFET device 1 is to be fabricated the material may be selected to yield a silicide having an n-type work function. The work function of the silicide may then have a value from about the middle of the energy gap of the semiconductor material which is to be silicided to about the bottom of the conduction band thereof. For example, if silicon is used as a semiconductor material, the work function of the silicide ranges from about 4.2eV to about 4.7eV. If a p-type MOSFET device 1 is to be fabricated, suitable metals are selected to yield a silicide having a p-type work function. The work function of the silicide may then have a value from about the middle of the energy gap of the semiconductor material which is to be silicided to about the top of the valence band thereof. For example, if silicon is used as semiconductor material the work function of the silicide ranges from about 4.7eV to about 5.2eV. Preferably the work function of the silicide may have a value about halfway the bottom of the conduction band and the top of the valence band with a variation of 10%. In this way, a midgap material may be obtained which is suitable to be used for n-type devices and for p-type devices. Furthermore, because the difference in work function of the gate and of the channel is reduced, the threshold voltage Vₜ of the device may also be reduced. If silicon is used as a semiconductor material the work function of the silicide preferably is about 4.7eV±0.2eV.

The type and the concentration of work function modulating element 6 is selected depending on the required work function of the silicide formed and on the work function desired for the type of MOSFET device. The concentration of work function modulating element 6 may vary from 1e14 cm⁻³ to 1e16 cm⁻³.

If, for example, a nickel silicide FUSI gate 4 is formed, typically a work function value of about 4.7 eV may be obtained. This work function can be tuned to be closer to the conduction band of silicon i.e. towards a value of 4.1eV, if an n-type MOSFETs is to be fabricated. Such a lowering in work function can be obtained by doping the nickel silicide with elements such as a lanthanide, e.g. Ytterbium (Yb), or elements such as Arsenic (As), Antimony (Sb) or Phosphorus (P).

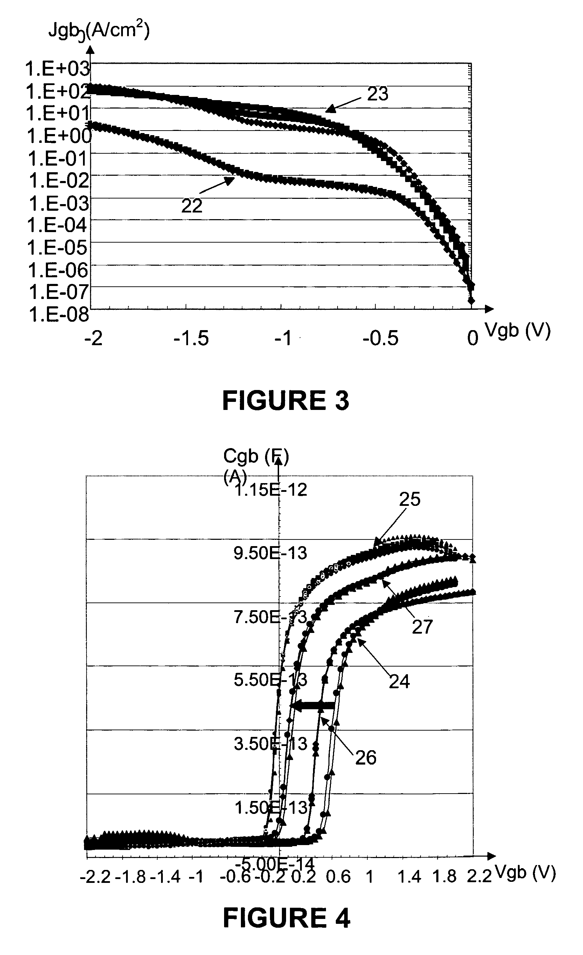

For instance, H.Y. Yu et al discloses in "Modulation of the Ni FUSI work function by Yb doping: from midgap to n-type band-edge" in technical digest IEDM meeting 2005, p630-633, in figure 3(b) and the corresponding paragraph on page 601, that the value of the work function of nickel silicide can be varied from about 4.7eV to about 4.2eV by varying the ratio of Yb to Ni. Furthermore, the work function can be tuned to a value closer to the valence band of silicon i.e. towards a value of 5.2eV, for instance in case a p-type MOSFET is to be fabricated. Such a shift in the value of the work function can be obtained by doping the nickel silicide of gate 4 with elements such as Platinum (Pt) or boron (B).

The diffusion preventing dopant element 5 may be selected from the group of Phosphorus (P), Silicon (Si), Germanium (Ge), Arsenic (As), Tin (Sn), or Antimony (Sb). The concentration of diffusion preventing dopant element 5 can vary from 1e14 cm⁻³ to 1e16 cm⁻³. Preferably, as already described above, the concentration of diffusion preventing dopant element 5 may be substantially equal to the concentration of work function modulating element 6.

According to embodiments of the invention, an n-type MOSFET device may be formed wherein the gate electrode 4 comprises a low work function metallic alloy comprising at least one lanthanide as work function modulating element 6, a suitable metal for silicidation, a diffusion preventing dopant element 5 retarding or substantially preventing the diffusion of a lanthanide towards and/or into the gate dielectric 3 and a semiconductor material, the semiconductor comprising Si, Ge or SiGe. In the context of the present invention, the lanthanides may comprise 15 elements from lanthanum to lutetium in the periodic table, including lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

According to embodiments of the invention the lanthanide may be Yb. According to embodiments of the invention, the metal may be Ni. According to embodiments of the invention, the semiconductor material may be Si.

According to embodiments of the invention, the gate electrode 4 may comprise Yb, Ni and/or Si.

In a preferred metallic alloy of the invention, the diffusion preventing dopant element, also referred to as diffusion-retarding element, may be phosphorus (P).

Figure 2 shows the gate capacitance (Cgb(F)) in function of the gate voltage (Vgb(V)), in curves measured for a capacitor structure comprising a prior art Yb-doped NiSi FUSI electrode (curve 20) and for a Yb+P-doped NiSi FUSI electrode according to an embodiment of the present invention (curve 21). If the prior art Yb-doped NiSi FUSI electrode is used a bump is observed in the capacitance-voltage curve as indicated by the dotted ellipse indicated by reference number 19. This bump 19 is indicative for the presence of interface states Dᵢₜ at the interface between the gate electrode 4 and the gate dielectric 3. Such a bump 19 is not observed in case an Yb+P-doped NiSi FUSI electrode according to an embodiment fo the present invention. In that case, the capacitance value varies smoothly with the applied voltage in the negative voltage range.

Figure 3 shows the gate current density (Jgb) vs. the gate voltage (Vgb) in curves obtained for a capacitor structure comprising a prior art NiSi FUSI gate electrode (curve 22) and for a prior art Yb-doped NiSi FUSI gate electrode. From this figure it is clear that if a prior art Yb-doped NiSi FUSI gate electrode is used (curve 23) the gate leakage current is increased compared to a prior art NiSi FUSI gate electrode without Yb (curve 22). The thickness of the silicon layer used to form the NiSi was varied from 100 nm to 40 nm, while a concentration of 4e15/cm² Yb was implanted with implant energies of 20 keV or 30 keV. If however a Yb+P doped NiSi FUSI electrode according to an embodiment of the invention is used, the increase in gate leakage current can be limited.

Figure 4 compares the gate capacitance (Cgb) vs. gate voltage (Vgb) characteristic obtained for a capacitor structure comprising a prior art NiSi FUSI gate electrode (curve 24), for a prior art Yb-doped NiSi FUSI gate electrode (curve 25), for a prior art P-doped NiSi FUSI gate electrode (curve 26) and for an Yb+P doped NiSi FUSI electrode according to an embodiment of the invention (curve 27). Compared to the structure with the NiSi FUSI gate electrode (curve 24), the largest shift in threshold voltage as indicated by the shift in the characteristics is obtained with the device with an Yb-doped NiSi FUSI gate electrode (curve 25). However, a similar shift in threshold voltage (see black arrow) may still be obtained when using an Yb+P-doped NiSi FUSI gate electrode according to embodiments of the invention (curve 27). Such Yb+P doped NiSi electrode thus offer an n-type work function, but also a decreased gate leakage current and a reduced number of interface states.

Various methods for fabricating a semiconductor device 1 according to embodiments of the invention and in particular the MOSFET device of Figure 1 are illustrated in the embodiments below.

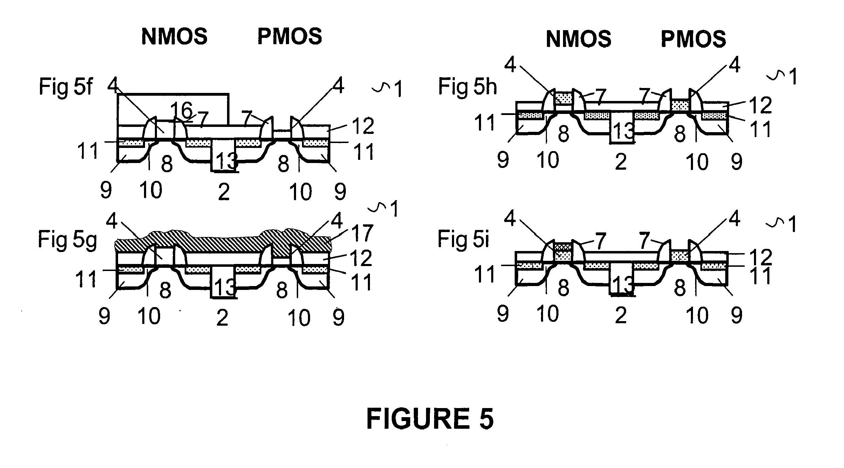

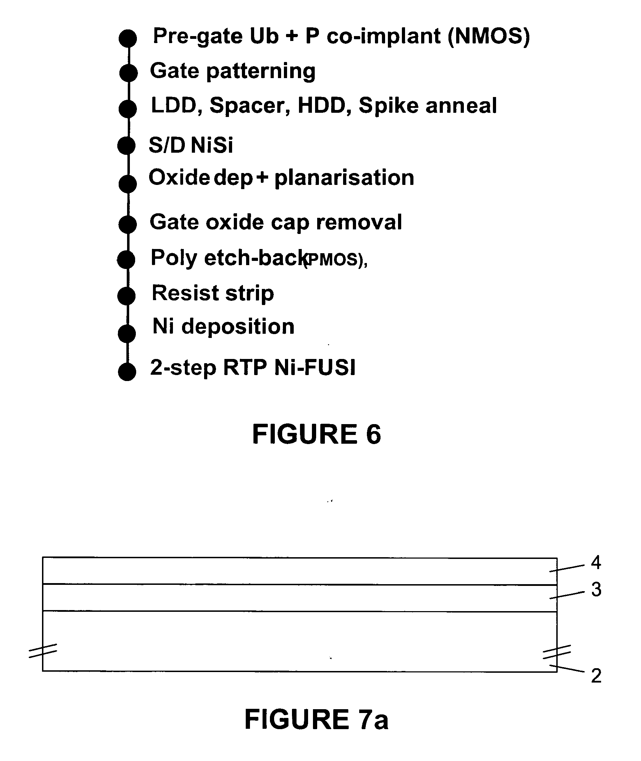

Figure 5a to 5i and Fig. 6 (flowchart) illustrate subsequent steps in a method for forming a MOSFET device 1 according to embodiments of the invention. The MOSFET device 14 may comprise a fully silicided gate electrode 4. The fabrication process illustrated that the method according to embodiments of the invention allows combining the fabrication of an n-type MOSFET device with a type MOSFET device on a same substrate 2. On the left side of the substrate 2 in Figures 5a to 5i an n-type MOSFET device is fabricated while on the right side of the substrate 2 a p-type MOSFET device is fabricated.

As shown in Figure 5a, first a substrate 2 is provided. The substrate 2 may comprise active regions NMOS and PMOS on which the respective MOSFET devices will be fabricated. These active regions are isolated from each other by dielectric regions 13, preferably formed using shallow-trench-isolation (STI) whereby grooves formed in the substrate 2 are filled with one or more dielectric layers. Onto the substrate 2 a stack of a gate dielectric layer 3 and a gate electrode layer 4 is formed. The gate dielectric layer 3 can be a silicon-oxide, a silicon oxynitride or a high-k dielectric such as hafnium silicates or hafnium oxides. The gate dielectric 3 may preferably be a silicon oxynitride layer. The gate electrode layer 4 can be formed of a semiconductor material. The thickness of the semiconductor layer 4 may be in the range of between 20 nm to 150 nm, and may, for example, be 100 nm. The semiconductor material may be silicon, such as polycrystalline silicon, or may be germanium or silicon-germanium.

On top of the gate electrode layer 4 a capping layer 14 can be formed (not illustrated as a separate layer in Fig. 5a) which can removed selectively with respect to the semiconductor layer 4. This capping layer may be a silicon-germanium layer. On top of the capping layer 14 a stop layer 15 can be formed which can be selectively removed with respect to the other layers on the substrate 2. This stopping layer 15 is used as a stopping layer in a chemical-mechanical processing step. The stopping layer 15 may be a silicon nitride layer.

In a next step, Ytterbium (Yb) 6 is implanted in the gate electrode layer 4, in the example given in the semiconductor layer 4, as indicated by the arrows in Figure 5a. This may be done uniformly. Preferably, at this stage, Yb is only implanted in that part of the semiconductor layer 4 where an NMOS is to be formed. As shown in Figure 5a a protective layer 16 such as a photoresistive layer may then be formed on the area where a PMOS devices is to be formed. The Yb implant dose may be in the range of between 1e15 cm⁻³ and 1e16cm⁻³, and may for example be 4e15cm⁻³. The Yb implant energy may be in the range of between 5 keV and 40 keV, or in the range of between 20 keV and 40 keV.

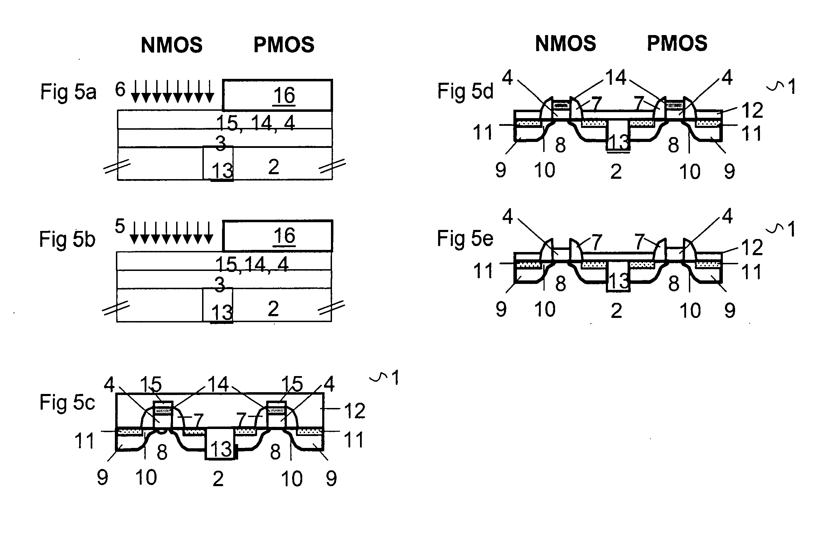

Using the protective layer 16 as a mask the diffusion preventing dopant element 5 is implanted in the NMOS part of the gate electrode layer 4, as indicated by the arrows in Figure 5b. Ion implantation may be used to implant the diffusion preventing dopant element 5 in the gate electrode layer 4. If, for example, an ytterbium doped nickel silicide is to be formed, this diffusing preventing dopant element 5 may be P. The P implant dose preferably may be the range of between 1e15 cm⁻³ and 1e16cm⁻³, and may for example be 4e15cm⁻³. The P implant energy may be in the range of 5 keV to 15 keV, or in the range of between 6 keV to 10 keV. After implantation the protective layer 16 may be removed. This may be done by any suitable technique known by a person skilled in the art.

As shown in Figure 5c the gate stack 3, 4, 14, 15 may be patterned. In the substrate 2, lowly doped junction regions 10 may be formed aligned to the gate stack 3, 4, 14, 15. Sidewall spacers 7 may then be formed against the sidewalls of the gate stack 3, 4, 14, 15. These sidewall spacers 7 may be formed of a dielectric material such as silicon oxide, silicon nitride, silicon carbide or a combination thereof. Aligned to the sidewall spacers 7 highly doped junction regions 9 may be formed in the substrate 2. The lowly doped regions 10 and the highly doped regions 9 may form the source and drain regions of the MOSFET device and may be formed on opposite sides of a channel region 8. A thermal treatment, such as a spike anneal can be performed after the implantation step to form the lowly doped regions 10 and the highly doped regions 9.

Thereafter, a layer of nickel is deposited over the substrate 2 followed by silicidation of the semiconductor material of the gate electrode 4. In a two step thermal process the exposed source and drain 9 regions are silicided. Preferably about 10 to 50nm nickel is deposited. The Ni layer may, for example, have a thickness of 10 nm. In a first temperature step the temperature can range from 150°C to 350°C, for a period of between 10s and 5 minutes. For example, the temperature of the first thermal step may 300°C during a time period of 30s. After the first thermal step the unreacted nickel may be removed by, for example, using a wet etch such as HCl comprising etching. Then a second thermal step may be performed. In this second thermal step, the temperature may range from 300°C to 550°C for a period of between 10s and 5 minutes. For example, the temperature of the second thermal step may be 470°C for a time period of 30s.

A planarizing layer 12 may then be deposited over the substrate 2 (see Figure 5c). The planarizing layer 12 may be a silicon oxide layer deposited using, for example, chemical vapour deposition (CVD).

As shown in Figure 5d, the planarizing layer 12 may be polished by e.g. using chemical-mechanical-polishing (CMP). The polishing stops when the stopping layer 15 is reached. In Figure 5d a dry etch is then further used to uniformly remove the planarizing layer 12 whereby the stopping layer 15 protects the underlying semiconductor gate electrode 4. The stopping layer 15 may then be removed, for example by using a dry etch process, as is shown in figure 5d.

As shown in Figure 5e the capping layer 14 may be removed as well, for example by using a dry etch process. The semiconductor gate electrodes 4 of the n-type MOSFET (left) and p-type MOSFET (right) are thereby exposed. The thickness of the semiconductor layer 4 and of the capping layer 14 may be chosen such that their combined thickness in the NMOS region equals their combined thickness in the PMOS region. However the ratio semiconductor layer thickness to capping layer thickness may be different in the NMOS region with respect to the PMOS region.

As shown in Figure 5f, now a protective layer 16 may be formed over the NMOS region. The protective layer 16 may be a photosensitive layer. Using the protective layer 16 as a mask the exposed semiconductor gate electrode 4 of the p-type MOSFET may partially be removed, for example by using a dry etch, to reduce the thickness of the semiconductor gate electrode 4 from for example 100 nm to between 30 nm to 50 nm. After thinning down the gate electrode 4 of the p-type MOSFET the protective layer 16 may be removed.

As shown in Figure 5g a layer of silicide-forming metal 17 may then be deposited over the structure. The metal layer 17 may be a nickel or a nickel alloy layer. The metal layer 17 may have a thickness of between 10 nm to 150 nm, or between 40 nm and 80 nm, an may for example be 60 nm.

As shown in Figure 5h a first thermal process step may be performed to have the deposited metal layer 17 react with the P- and Yb- doped nMOS semiconductor gate electrode 4 and with the pMOS semiconductor gate electrode 4. In the first temperature step the temperature can range from 250°C to about 450°C, for a period of between 10s and 5 minutes. For example, the temperature of the first thermal step may be 370°C for a time period of 30s. Thereafter the unreacted metal 17 may be selectively removed, for example by using a wet etch. As the thickness of the pMOS semiconductor gate electrode 4 is less than the thickness of the nMOS semiconductor gate electrode 4 (see Figure 5f), the pMOS gate electrode 4 will already be fully silicided during the first thermal step and a metal-rich silicide will be obtained. The nMOS gate electrode 4 will only be partially silicided, leaving a semiconductor portion adjacent to the gate dielectric 3. As shown in Figure 5i during the second thermal step the partially silicided gate nMOS gate electrode 4 may become fully silicided as the un-silicided bottom portion of the nMOS gate electrode will also react with the silicide-forming metal in the silicided portion. Preferably a fully silicided nMOS gate electrode 4 may be obtained with a metal-to-semiconductor ratio lower then for the fully silicided pMOS gate electrode 4.

In the embodiments below variations on the process sequence illustrated by Figures 5a to 5i and Figure 6 above will be discussed. For the purpose of describing the invention only the steps and the schematic cross-sections relevant to the fabrication of an n-type MOSFET are shown.

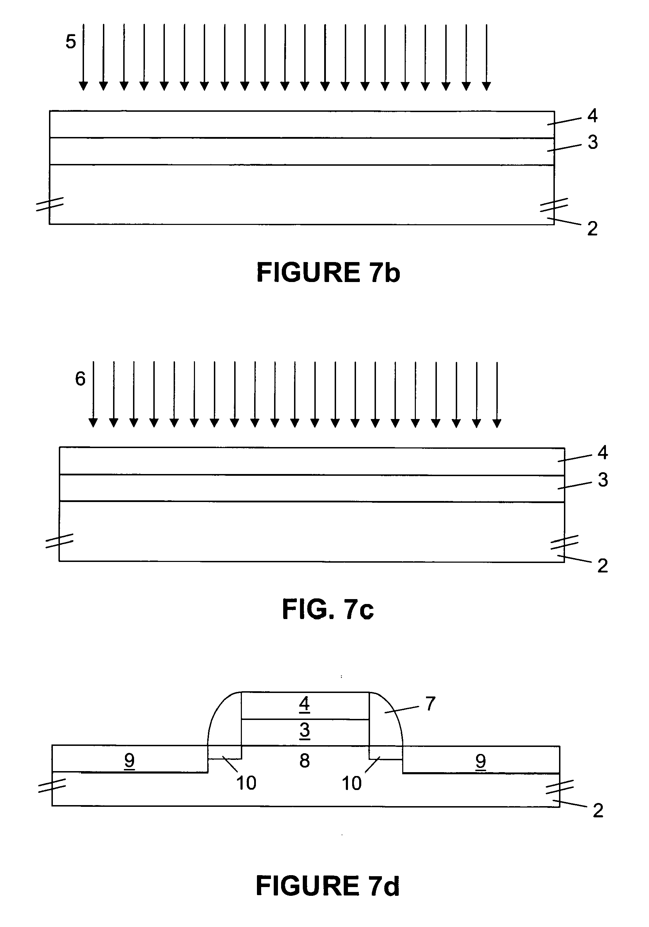

Another embodiment of the method according to the present invention is illustrated in figures 7a to 7e.

As shown in Figure 7a, a substrate 2 is provided on which a gate stack formed of a gate dielectric layer 3 and a gate electrode layer 4 is provided. The gate dielectric layer 3 can be a silicon-oxide, a silicon oxynitride or a high-k dielectric such as hafnium silicates or hafnium oxides. The gate electrode layer 4 may be formed in semiconductor material. The semiconductor material may be silicon, such as polycrystalline silicon, or may be germanium or silicon-germanium.

As indicated by the arrows in Figure 7b a diffusion preventing dopant element 5 is incorporated in the gate electrode 4. The diffusion preventing dopant element 5 is selected to modulate, i.e. to substantially prevent or at least retard, the diffusion of the work function modulating element 6 from the silicided gate 4 towards and/or into the gate dielectric 3. If an ytterbium nickel silicide is to be formed, preferably phosphorus may be incorporated in the gate electrode 4. To introduce the diffusion preventing dopant element 5 in the gate electrode layer 4 ion implantation may be used.

As shown in Figure 7c, after incorporating the diffusion preventing dopant element 5 in the gate electrode layer 4 a work function modulating element 6 is incorporated in the gate electrode 4. This is indicated with the arrows in Figure 7c. This work function modulating element 6 will later react with the silicide-forming metal 17 and the semiconductor gate electrode 4 to form a fully silicided gate electrode 4. Although in figures 7a to 7e the diffusion preventing dopant element 5 is introduced into the semiconductor gate electrode 4 prior to introduction of the work function modulating element 6, the invention is not limited hereto. According to other embodiments of the invention, first the work function modulating element 6 is introduced and subsequently the diffusion preventing dopant element 5 is introduced.

As shown in Figure 7d the stack formed of the gate dielectric 3 and the semiconductor gate electrode 4 comprising the diffusion preventing dopant element 5 and the work function modulating element 6 is patterned to form the gate stack of a MOSFET device 1. The region in the substrate 2 which is under dielectric control of the gate electrode 4 will form the channel region 8 of the transistor. The processing of the MOSFET device is continued by forming in the substrate 2, highly doped regions 9 and lowly doped regions 10 aligned to the gate stack formed by the gate dielectric 3 and gate electrode 4. The doped regions 9, 10 can be formed by, for example, ion implantation. Sidewall spacers 7 may be formed against sidewalls of the gate stack 3, 4. A layer of nickel may then be deposited over the substrate 2. In a two step thermal process the exposed highly doped regions 9 may be silicided.

A layer of silicide-forming metal 17 is deposited over the substrate 2 as shown in Figure 7e. The thickness of this metal layer 17 may be selected to yield a fully silicided gate electrode 4.

During thermal processing the silicide-forming metal 17 will react with the semiconductor material comprising the work function modulating element 6 and the diffusion preventing dopant element 5 to form a silicide 11. If the semiconductor material of the substrate 1 is silicon, germanium or silicon-germanium, silicide 11 may also be formed at the doped regions 9. As is appreciated by a person skilled in the art, thermal processing to form the silicide 11 may be done as follows. Firstly, a first thermal step is performed, e.g. an annealing step. Then unreacted metal 17 is selectively removed. Optionally a second thermal step may be performed to, for example, reduce the sheet resistance of the silicide formed during the first thermal step or to fully silicidize the gate electrode 4 if necessary. The step of fully siliciding the semiconductor material of the gate electrode 4 may thus comprise the step of providing a thermal budget to convert substantially all the semiconductor material into a silicide 11 and the step of removing any unreacted metal. Finally a MOSFET device 1 is obtained as shown in Figure 1.

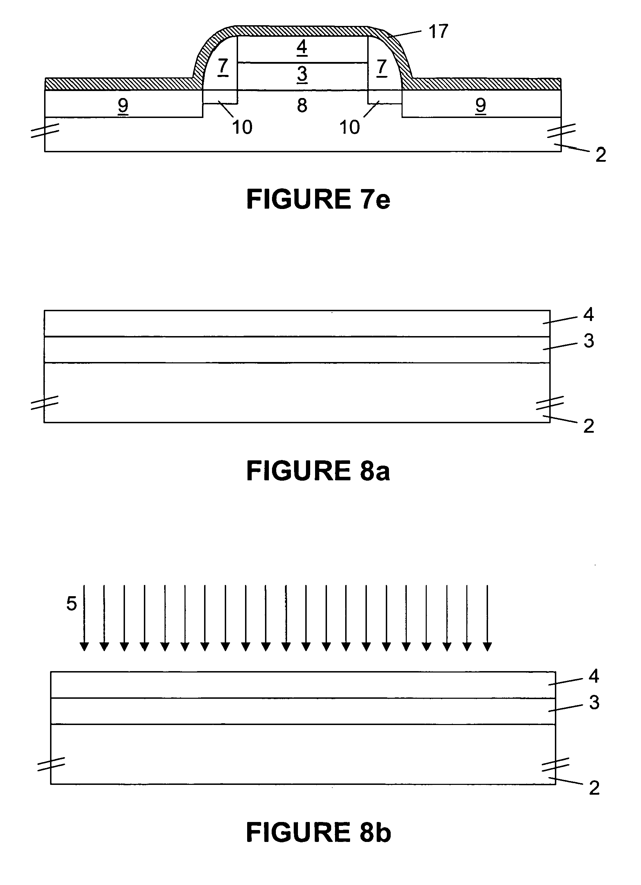

A further embodiment of the method according to the present invention is illustrated in Figures 8a to 8e.

As shown in figure 8a, a substrate 2 is provided on which a stack of a gate dielectric layer 3 and a gate electrode layer 4 is formed. The gate dielectric layer 3 can be a silicon-oxide, a silicon oxynitride or a high-k dielectric such as hafnium silicates or hafnium oxides. The gate electrode layer 4 may be formed of a semiconductor material. The semiconductor material can be silicon, such as polycrystalline silicon, or can be germanium or silicon-germanium.

As shown in figure 8b a diffusion preventing dopant element 5 is incorporated in the gate electrode 4, as indicated by the arrows. This diffusion preventing dopant element 5 may be selected to modulate, i.e. to substantially prevent, or retard the diffusion of the work function modulating element 6 from the silicided gate 4 towards and/or into the gate dielectric 3. If an ytterbium nickel silicide is to be formed, preferably phosphorus may be incorporated in the gate electrode 4. Ion implantation may be used to introduce the diffusion preventing dopant element 5 in the gate electrode layer 4.

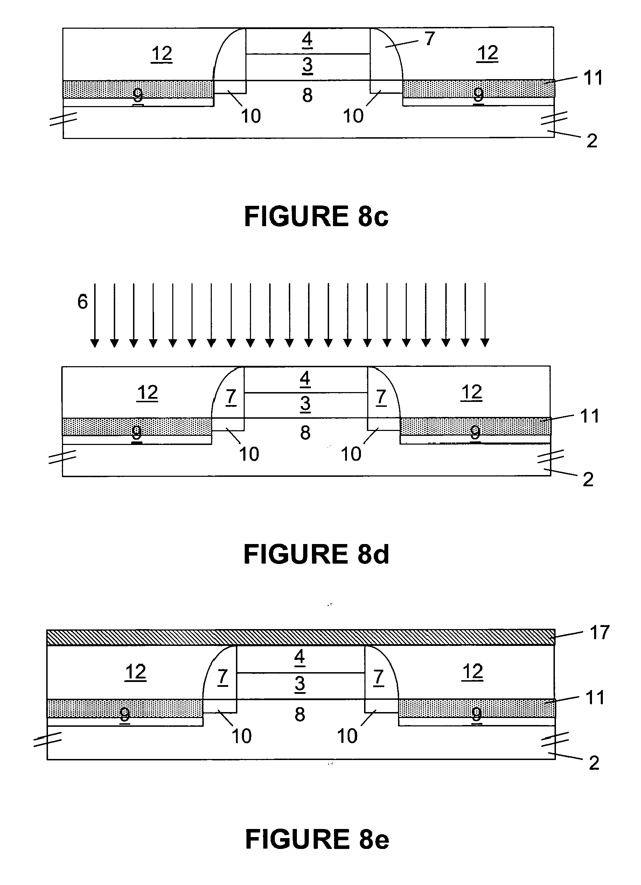

As shown in Figure 8c, the stack of the gate dielectric 3 and the semiconductor gate electrode 4 comprising the diffusion preventing dopant element 5 may be patterned to form the gate stack 3, 4 of a MOSFET device 1. The region in the substrate 2 which is under dielectric control of the gate electrode 4 may form the channel region 8 of the device 1. The processing of the MOSFET device 1 according to the present embodiment may be continued by forming in the substrate 2 lowly and highly doped regions 9, 10 aligned to the gate stack 3, 4. For example lowly doped regions 10 may be formed in the substrate 2 aligned to the gate stack 3, 4. Sidewall spacers 7 may be formed against sidewalls of the gate stack 3, 4. Highly doped regions 9 may be formed in the substrate 2. These doped regions 9, 10 may, for example, be formed by ion implantation. A layer of nickel may then be deposited over the substrate 2. In a two step thermal process the exposed highly doped regions 9 may be silicided.

A planarizing layer 12 may then be deposited over the structure. The planarization layer 12 may be a silicon oxide layer deposited using chemical vapour deposition (CVD). The planarization layer 12 can be planarized using chemical-mechanical polishing until the semiconductor gate electrode 4 is exposed (see Figure 8d). As shown by the arrows in Figure 8d a work function modulating element 6 is incorporated in the exposed semiconductor gate electrode 4. This may be done by, for example, ion implantation. This work function modulating element 6 will later react with the silicide-forming metal 17 and the semiconductor gate electrode 4 to form a fully silicided gate electrode 4.

A layer of silicide-forming metal 17 may then be deposited as shown in Figure 8e. The thickness of this metal layer 17 may be selected to yield a fully silicided gate electrode 4. During thermal processing the silicide-forming metal 17 will react with the semiconductor gate electrode 4 comprising the work function modulating element 6 and the diffusion preventing dopant element 5 to form a silicide 11. Silicidation may be performed by performing a thermal anneal process. The thermal anneal process may comprise a first anneal step. After this first anneal step, unreacted metal 17 may selectively be removed. Optionally a second thermal step may be performed to, for example, reduce the sheet resistance of the silicide formed during the first thermal step or to fully silicidize the gate electrode 4 if required. The step of fully siliciding the semiconductor material of the gate electrode 4 thus comprises the step of providing a thermal budget to convert substantially all the semiconductor material into a silicide and the step of removing any unreacted metal. Finally a MOSFET device 1 is obtained as shown in Figure 1.

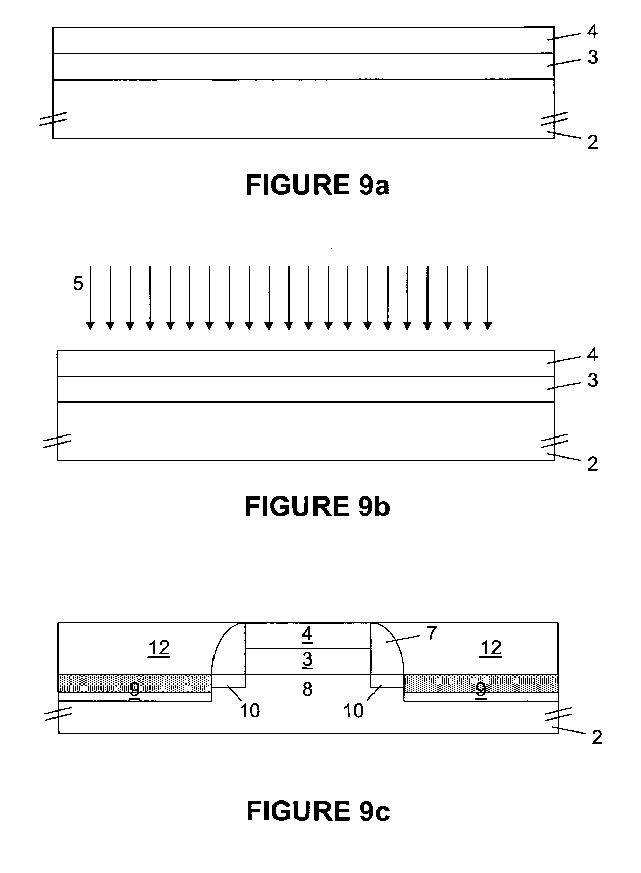

A further embodiment of the method according to the present invention is illustrated by Figures 9a to 9d.

As shown in Figure 9a a substrate 2 is provided on which a stack of a gate dielectric layer 3 and a gate electrode layer 4 is formed. The gate dielectric layer 3 can be a silicon-oxide, a silicon oxynitride or a high-k dielectric such as hafnium silicates or hafnium oxides. The gate electrode layer 4 may be formed of a semiconductor material. The semiconductor material may be silicon, such as polycrystalline silicon, or may be germanium or silicon-germanium.

As shown by the arrows in Figure 9b a diffusion preventing dopant element 5 is incorporated in the gate electrode 4. This diffusion preventing dopant element 5 is selected to modulate, i.e. to substantially prevent, or retard the diffusion of the work function modulating element 6 from the silicided gate 4 towards and/or into the gate dielectric 3. If an ytterbium nickel silicide is to be formed, preferably phosphorus may be incorporated in the gate electrode 4. Ion implantation may be used to introduce the diffusion preventing dopant element 5 in the gate electrode layer 4.

As shown in Figure 9c the stack of the gate dielectric 3 and the gate electrode 4 comprising the diffusion preventing dopant element 5 may be patterned to form the gate stack 3, 4 of a MOSFET device 1. The region in the substrate 2 which is under dielectric control of the gate electrode 4 may form the channel region 8 of the device 1. The processing of the MOSFET device 1 may be continued by forming in the substrate 2 highly and lowly doped regions 9, 10 aligned to the gate stack 3, 4. For example lowly doped regions 10 may be formed in the substrate 2 aligned to the gate stack 3, 4. Sidewall spacers 7 may be formed against sidewalls of the gate stack 3, 4. Highly doped regions 9 may be formed in the substrate 2. These doped regions 9, 10 can be formed by, for example, ion implantation. A layer of nickel may then be deposited over the substrate 2. In a two step thermal process the exposed highly doped regions 9 may be silicided.

A planarizing layer 12 may then be deposited over the structure. The planarization layer 12 may be a silicon oxide layer deposited using, for example, chemical vapour deposition (CVD). The planarization layer 12 can be planarized using chemical-mechanical polishing until the gate electrode 4 is exposed.

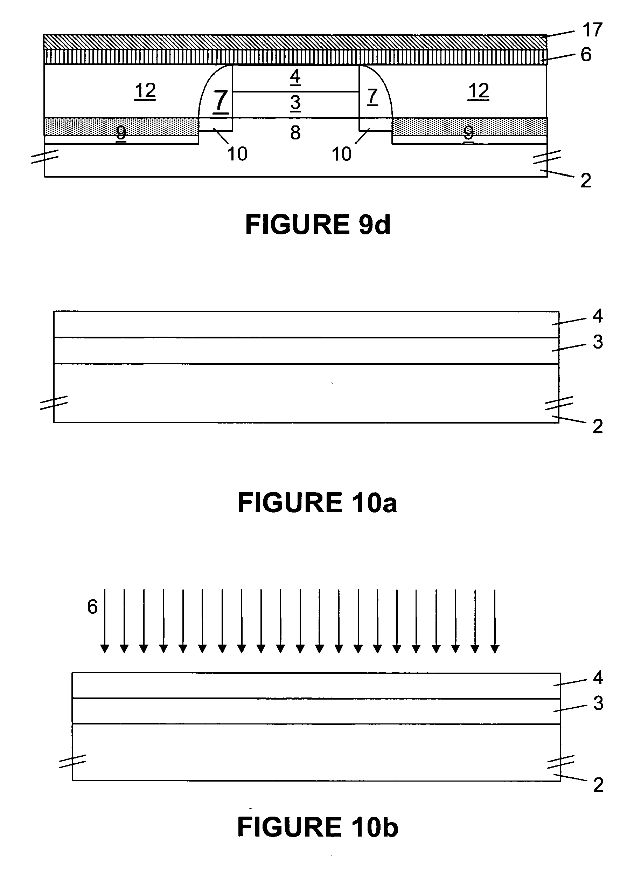

As shown in Figure 9d a layer of a work function modulating element 6 may be deposited over the exposed semiconductor gate electrode 4. A layer of silicide-forming metal 17 may then be deposited over the layer of work function modulating element 6. The thickness of this metal layer 17 may be selected to yield a fully silicided gate electrode 4. During thermal processing the silicide-forming metal 17 and the element 6 will react with exposed semiconductor gate electrode 4 comprising the dopant 5 to form a silicide 11. As is appreciated by a person skilled in the art the thermal processing comprises a first thermal step. The unreacted metal 8 and work function modulating element 6 may then selectively be removed. Optionally a second thermal step is performed to, for example, reduce the sheet resistance of the silicide formed during the first thermal step. The step of fully siliciding the semiconductor material of the gate electrode 4 thus comprises the step of providing a thermal budget to convert substantially all the semiconductor material into a silicide and the step of removing any unreacted metal. Finally a MOSFET device 1 is obtained as shown in Figure 1.

A further embodiment of method according to the invention is illustrated in Figures 10a to 10d.

As shown in Figure 10a a substrate 2 is provided on which a stack of a gate dielectric layer 3 and a gate electrode layer 4 is formed. The gate dielectric layer 3 can be a silicon-oxide, a silicon oxynitride or a high-k dielectric such as hafnium silicates or hafnium oxides. The gate electrode layer 4 may be formed of a semiconductor material. The semiconductor material may be silicon, such as polycrystalline silicon, or may be germanium or silicon-germanium.

As shown in Figure 10b a work function modulating element 6 is incorporated in the semiconductor layer 4 as indicated by the arrows. Ion implantation may be used to introduce the work function modulating element 6 in the semiconductor layer 4. This work function modulating element 6 will later react with the silicide-forming metal 17 and the material of the gate electrode 4 to form a fully silicided gate electrode 4.

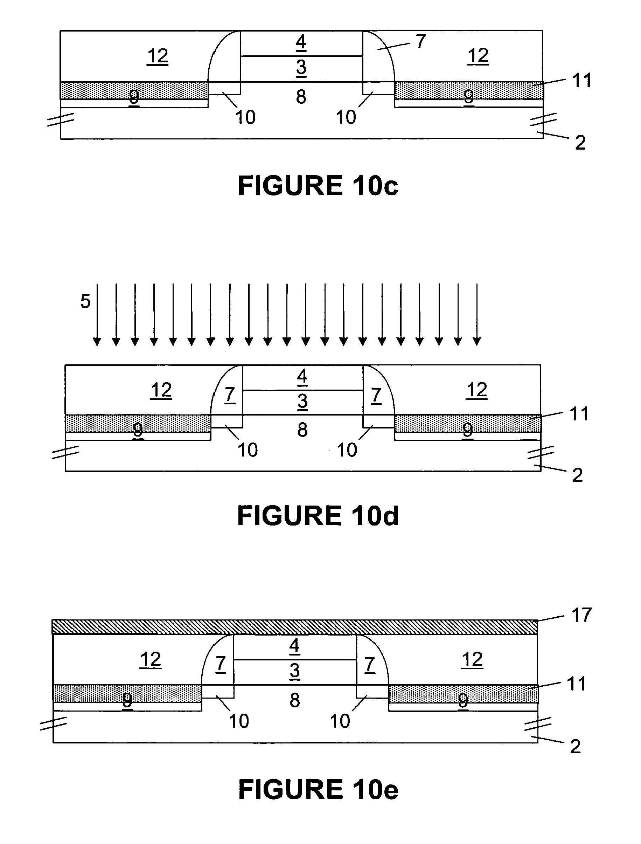

As shown in Figure 10c the stack of the gate dielectric 3 and the semiconductor gate electrode 4 comprising the work function modulating element 6 is patterned to form the gate stack 3, 4 of a MOSFET device 1. The region in the substrate 2 which is under dielectric control of the gate electrode 4 may form the channel region 8 of the transistor. The processing of the MOSFET device 1 may be continued by forming in the substrate 2 highly doped and lowly doped regions 9, 10 aligned to the gate stack of gate dielectric 3 and gate electrode 4. For example lowly doped regions 10 may be formed in the substrate 2 aligned to the gate stack 3, 4. Sidewall spacers 7 may be formed against sidewalls of the gate stack 3, 4. Highly doped regions 9 may be formed in the substrate 2. These doped regions 9, 10 can be formed by, for example, ion implantation. A layer of nickel is deposited over the substrate 2. In a two step thermal process the exposed source and drain 9 regions are silicided.

A planarizing layer 12 may then be deposited over the structure. The planarizing layer 12 may be a silicon oxide layer deposited using chemical vapour deposition (CVD). The planarizing layer 12 can be planarized using chemical-mechanical polishing until the gate electrode 4 is exposed.

As shown by the arrows in Figure 10d a diffusion preventing dopant element 5 may be incorporated in the exposed semiconductor gate electrode 4. This dopant 5 is selected to modulate, i.e. to substantially prevent, or retard the diffusion of the work function modulating element 6 from the silicided gate 4 towards and/or into the gate dielectric 3. If an ytterbium nickel silicide is to be formed, preferably phosphorus may be incorporated in the gate electrode 4. Ion implantation may be used to introduce the diffusion preventing dopant element 5 in the gate electrode 4.

As shown in Figure 10e a layer of silicide-forming metal 17 may be deposited over the layer of the work function modulating element 6. The thickness of this metal layer 17 may be selected to yield a fully silicided gate electrode 4. During thermal processing the silicide-forming metal 17 will react with exposed semiconductor gate electrode 4 comprising the diffusion preventing dopant element 5 and the work function modulating element 6 to form a silicide 11. As is appreciated by a person skilled in the art the thermal processing comprises a first thermal step. The unreacted metal 8 and element 6 are then selectively removed. Optionally a second thermal step is performed to, for example, reduce the sheet resistance of the silicide formed during the first thermal step. The step of fully siliciding the semiconductor material of the gate electrode 4 thus comprises the step of providing a thermal budget to convert substantially all the semiconductor material into a silicide and the step of removing any unreacted metal. Finally a MOSFET device 1 is obtained as shown in Figure 1.

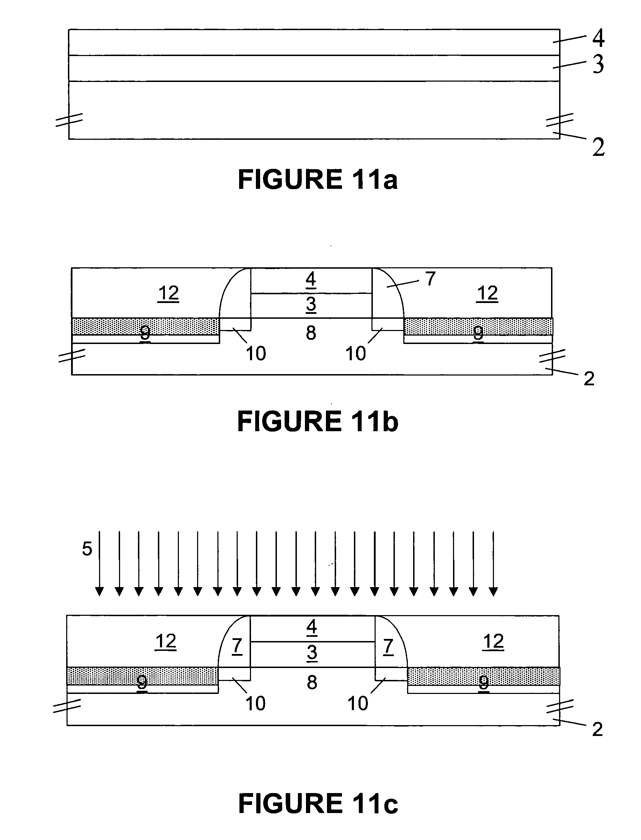

A further embodiment of the method according to the invention is illustrated in Figures 11a to 11d.

As shown in Figure 11a a substrate 2 is provided on which a stack of a gate dielectric layer 3 and a gate electrode layer 4 is formed. The gate dielectric layer 3 can be a silicon-oxide, a silicon oxynitride or a high-k dielectric such as hafnium silicates or hafnium oxides. The gate electrode layer 4 may be formed of a semiconductor material. The semiconductor material can be silicon, such as polycrystalline silicon, or can be germanium or silicon-germanium.

As shown in Figure 11b the stack of the gate dielectric 3 and the semiconductor gate electrode 4 may be patterned to form the gate stack of a MOSFET device1. The region in the substrate 2 which is under dielectric control of the gate electrode 4 may form the channel region 8 of the device1. The processing of the MOSFET device 1 may then be continued by forming in the substrate 2 highly doped and lowly doped regions 9, 10 aligned to the gate stack 3, 4. For example lowly doped regions 10 may be formed in the substrate 2 aligned to the gate stack 3, 4. Sidewall spacers 7 may be formed against sidewalls of the gate stack 3, 4. Highly doped regions 9 may be formed in the substrate 2. These doped regions 9, 10 can be formed by, for example, ion implantation. A layer of nickel may be deposited over the substrate 2. In a two step thermal process the exposed highly doped regions 9 may be silicided. A planarizing layer 12 may then be deposited over the structure. The planarizing layer 12 may be a silicon oxide layer deposited using chemical vapour deposition (CVD). The planarizing layer 12 can be planarized using chemical-mechanical polishing until the gate electrode 4 is exposed.

As shown in Figure 11c a diffusion preventing dopant element 5 is incorporated in the exposed gate electrode 4. This diffusion preventing dopant element 5 may be selected to modulate, i.e. to substantially prevent, or retard the diffusion of the work function modulating element 6 from the silicided gate 4 towards and/or into the gate dielectric 3. If an ytterbium nickel silicide is to be formed, preferably phosphorus may be incorporated in the gate electrode 4. Ion implantation may be used to introduce the diffusion preventing dopant element 5 in the gate electrode 4.

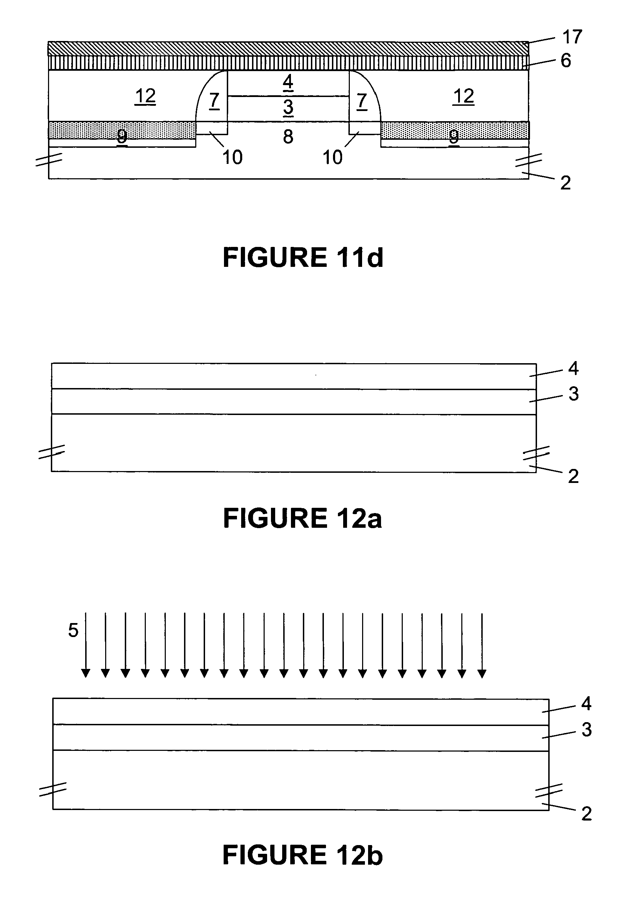

As shown in Figure 11d a layer of a work function modulating element 6 may be deposited over the exposed gate electrode 4. A layer of silicide-forming metal 17 may then deposited over the layer of work function modulating element 6. The thickness of this metal layer 17 may be selected to yield a fully silicided gate electrode 4. During thermal processing the silicide-forming metal 17 and the work function modulating element 6 will react with exposed semiconductor gate electrode 4 comprising the diffusion preventing dopant element 5 to form a silicide 11. As is appreciated by a person skilled in the art the thermal processing comprises a first thermal step. The unreacted metal 17 and element 6 are then selectively removed. Optionally a second thermal step is performed to, for example, reduce the sheet resistance of the silicide formed during the first thermal step. The step of fully siliciding the semiconductor material of the gate electrode 4 thus comprises the step of providing a thermal budget to convert substantially all the semiconductor material into a silicide and the step of removing any unreacted metal. Finally a MOSFET device 1 is obtained as shown in Figure 1.

According to further embodiments of the invention the gate electrode layer 4 may comprise a metal or a stack of metal layers. Instead of metal also conductive metal nitrides, metal oxides, metal carbides or metal silicon nitrides can be used. Examples of such conductive metals or metal-based materials suitable to be used for the gate electrode layer4 may be Ti, TiN, Ta, TaN, , TaC, TaCN, TaSiN, TiSiN, W, Mo. Such gate electrode stacks can comprise a metal-based layer with a thickness in the range of between 2 and 10 nm which may be capped with a polysilicon layer having a thickness in the range of between 40 nm and 100 nm. A possible implementation of this embodiment is illustrated in Figures 12a to 12d.

As shown in Figure 12a a substrate 2 is provided on which a stack of a gate dielectric layer 3 and a gate electrode layer 4 is formed. The gate dielectric layer 3 can be a silicon-oxide, a silicon oxynitride or a high-k dielectric such as hafnium silicates or hafnium oxides. The gate electrode layer 4 may comprise a metal or a stack of metal layers, optionally capped with a polysilicon layer.

As shown by the arrows in Figure 12b a diffusion preventing dopant element 5 is incorporated in the gate electrode 4. This diffusion preventing dopant element 5 is selected to modulate, i.e. to substantially prevent, or retard the diffusion of the work function modulating element 6 from the metallic gate 4 towards and/or into the gate dielectric 3.

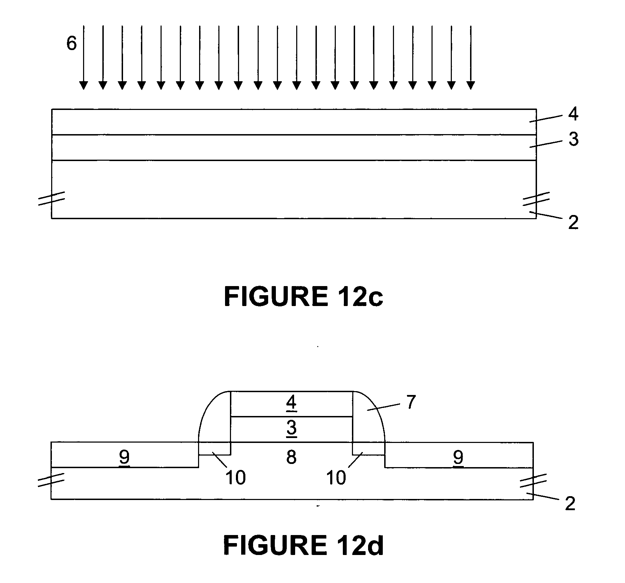

As shown by the arrows in Figure 12c after incorporating the diffusion preventing dopant element 5 in the gate electrode layer 4 a work function modulating element 6 is incorporated in the gate electrode 4. Although in Figures 12a to 12e the diffusion preventing dopant element 5 is introduced into the gate electrode 4 prior to the work function modulating element 6 the invention is not limited hereto. According to other embodiments of the invention, first the work function modulating element 6 can be introduces and afterwards the diffusion preventing dopant element 5 can be introduced.

As shown in Figure 12d the stack of the gate dielectric 3 and the gate electrode 4 comprising the diffusion preventing dopant element 5 and the work function modulating element 6 may be patterned to form the gate stack of a MOSFET device 1. The region in the substrate 2 which is under dielectric control of the gate electrode 4 may form the channel region 8 of the device 1. The processing of the MOSFET device 1 may then be continued by forming in the substrate 2 highly doped and lowly doped regions 9, 10 aligned to the gate stack 3, 4. For example lowly doped regions 10 may be formed in the substrate 2 aligned to the gate stack 3, 4. Sidewall spacers 7 may be formed against sidewalls of the gate stack 3, 4. Highly doped regions 9 can be formed in the substrate 2. These doped regions 9, 10 may be formed by ion implantation.

During subsequent thermal processing the work function modulating element 6 and the diffusion preventing dopant element 5 may react.

Instead of introducing both the work function modulating element 6 and the diffusion preventing dopant element 5 in the gate electrode 4 before patterning thereof, other schemes for introducing the element 6 and the diffusion preventing dopant element 5 can be envisaged according to other embodiments of the invention. The work function modulating element 6 and the diffusion preventing dopant element 5 can be introduced respectively before and after patterning of the gate electrode 4 or vice versa. The work function modulating element 6 and the diffusion preventing dopant element 5 can both be introduced after patterning of the gate electrode 4. If one of the diffusion preventing dopant element 5 or the work function modulating element 6 is introduced after gate patterning then first a planarizing layer 12 may be deposited over the substrate 2 and may be patterned so as to expose the gate electrode 4. Thereafter the diffusion preventing dopant element 5 or the work function modulating element 6 may be introduced in the exposed gate electrode 4.

For the purpose of describing the invention only the steps and the schematics relevant to the n-type MOSFET have been shown. A person skilled in the art will realize that if a p-type MOSFET gate electrode 4 is to be formed the process steps disclosed in embodiments of the invention can also be applied to form such a p-type gate electrode 4.

It is to be understood that although preferred embodiments, specific constructions and configurations, as well as materials, have been discussed herein for devices according to the present invention, various changes or modifications in form and detail may be made without departing from the scope of this invention as defined by the appended claims.

## Claims

1. A semiconductor device (1) comprising a main electrode (4) and a dielectric (3) in contact with the main electrode (4), the main electrode (4) comprising a material having a work function and a work function modulating element (6) for modulating the work function of the material of the main electrode (4) towards a predetermined value,
wherein the main electrode (4) furthermore comprises a diffusion preventing dopant element (5) for preventing diffusion of the work function modulating element (6) towards and/or into the dielectric (3).

2. A semiconductor device (1) according to claim 1, wherein the main electrode (4) is a fully silicided main electrode and the material of the main electrode (4) comprises an alloy of a semiconductor material and a metal.

3. A semiconductor device (1) according to claim 2, wherein the semiconductor material comprises silicon or germanium.

4. A semiconductor device (1) according to claim 2, wherein the metal is a metal that forms an alloy having a midgap work function.

5. A semiconductor device according to claim 1, wherein the material of the main electrode (4) comprises a metal.

6. A semiconductor device (1) according to any of the previous claims, wherein the diffusion preventing dopant element (5) is one of P, As, Sb, Ge or Si.

7. A semiconductor device (1) according to any of the previous claims, wherein the concentration of diffusion preventing dopant element (5) in the main electrode (4) is between 1e14 cm⁻³ and 1e16 cm⁻³.

8. A semiconductor device (1) according to any of the previous claims, wherein the work function modulating element (6) is selected to form a material with an n-type work function.

9. A semiconductor device (1) according to claim 8, wherein the work function modulating element (6) is selected from the group of lanthanides.

10. A semiconductor device (1) according to claim 9, wherein the work function modulating element (6) is Ytterbium.

11. A semiconductor device (1) according to any of the previous claims, wherein the concentration of work function modulating element (6) in the main electrode (4) is between 1e14 cm⁻³ and 1e16 cm-³.

12. A semiconductor device (1) according to any of claims 2 to 11, wherein the metal is nickel.

13. A semiconductor device (1) according to any of the previous claims, wherein the dielectric (3) is a silicon-oxide, a silicon oxynitride or a high-k dielectric.

14. A method for forming a semiconductor device (1), the method comprising:
- forming a main electrode structure comprising a main electrode (4) and a dielectric (3) in contact with the main electrode (4), the main electrode (4) comprising a material having a work function,
- providing a work function modulating element (6) to the main electrode (6) for modulating the work function of the material of the main electrode (4) towards a predetermined value, and
- providing a diffusion preventing dopant element (5) to the main electrode (4) for preventing diffusion of the work function modulating element (6) towards and/or into the dielectric (3).

15. Method according to claim 14, wherein forming a main electrode structure comprises:
- providing on a substrate (2) a dielectric layer and a layer of main electrode material to form a main electrode stack, and
- patterning the main electrode stack to form the main electrode (4).

16. Method according to claim 14, the main electrode comprising an alloy of a semiconductor material and a metal, wherein the method furthermore comprises, after patterning the main electrode stack:
- providing a layer (17) of metal on the main electrode (4), and
- silicidizing the main electrode (4).

17. Method according to any of claims 14 to 16, wherein providing the work function modulating element (6) is performed before providing the diffusion preventing dopant element (5).

18. Method according to any of claims 14 to 16, wherein providing the work function modulating element (6) is performed after providing the diffusion preventing dopant element (5).

19. Method according to any of claims 15 to 18, wherein providing the work function modulating element (6) is performed before or after patterning the main electrode stack.

20. Method according to any of claims 15 to 19, wherein providing the diffusion preventing dopant element (5) is performed before or after patterning the main electrode stack.

21. Method according to any of claims 14 to 20, wherein providing the diffusion preventing dopant element (5) is performed by ion implantation.

22. Method according to any of claims 14 to 21, wherein providing the work function modulating element (6) is performed by ion implantation.

23. Method according to any of claims 14 to 21, wherein providing the work function modulating element (6) is performed by providing a layer of the work function modulating element (6) and performing a thermal anneal.
